# EUROPÄISCHE PATENTSCHRIFT

(11) **EP 0 584 668 B1**
(45) Veröffentlichungstag und Bekanntmachung des Hinweises auf die Patenterteilung: **18.12.1996**
(21) Anmeldenummer: 93112961.3
(22) Anmeldetag: 12.08.1993
(51) Int. Cl.: H01L 25/18, H01L 23/538

(54) **Leistungshalbleiter-Modul**
Semi-conductor power module
Module semi-conducteur de puissance

(30) Priorität: 26.08.1992 EP 92114544
(43) Veröffentlichungstag der Anmeldung: 02.03.1994
(73) Patentinhaber: EUPEC Europäische Gesellschaft für Leistungshalbleiter mbH & Co. KG, D-59581 Warstein (DE); SIEMENS AKTIENGESELLSCHAFT, 80333 München (DE)
(72) Erfinder: Schulze, Gerhard, Dipl.-Ing., D-59557 Lippstadt (DE); Sommer, Karl-Heinz, Dr. rer. nat., D-59581 Warstein (DE); Spanke, Reinhold, Dipl.-Ing., D-59909 Bestwig (DE); Papp, Gyoergy, Dr., D-91058 Erlangen (DE); Springmann, Walter, D-91325 Adelsdorf (DE); Zwanziger, Peter, D-90453 Nürnberg (DE)
(74) Vertreter: Fuchs, Franz-Josef, Dr.-Ing.

(56) Entgegenhaltungen:
- EP-A- 0 166 968
- EP-A- 0 278 432
- DE-A- 4 032 370

## Beschreibung

Die Anmeldung bezieht sich auf ein Leistungshalbleiter-Modul mit einer Anzahl von sich entlang einer parallel zum Boden des Moduls liegenden Achse paarweise gegenüberliegenden, auf Leiterbahnen angeordneten und parallelgeschalteten Halbleiteranordnungen, mit eng benachbarten und einander parallelen bandförmigen Anschlußleitern, die mit den Leiterbahnen verbunden sind.

Ein solches Leistungshalbleiter-Modul ist z.B. bereits im europäischen Patent 0 427 143 und im deutschen Gebrauchsmuster G 9203000 beschrieben worden. Die nahe beieinanderliegenden parallelen bandförmigen Anschlußleiter verringern die Induktivität des Moduls. Bei dem im europäischen Patent beschriebenen Modul ist ein symmetrischer Aufbau mit vier Halbleiteranordnungen gezeigt.

Für hohe Ströme von z.B. 1000 A und hoher müssen mehrere Halbleiteranordnungen, z.B. sechs oder mehr einander parallel geschaltet werden. Bei den bekannten Modulen sind nun bei sechs oder mehr einander parallel geschalteten Halbleiteranordnungen die Wege von den Halbleiteranordnungen zu den Anschlußleitern unterschiedlich lang. Diese Unsymmetrie innerhalb des Moduls schränkt den ausnutzbaren Strom- und Spannungsbereich der einzelnen Halbleiteranordnungen ein, da die Eigenschaften des gesamten Moduls durch die Halbleiteranordnung mit der größten parasitären Induktivität bestimmt werden.

Ziel der Erfindung ist eine Verbesserung der elektrischen Eigenschaften.

Dieses Ziel wird dadurch erreicht, daß mindestens ein Paar und höchstens je zwei Paare von in Richtung der Achse hintereinanderliegenden Halbleiteranordnungen mit mindestens zwei der eng benachbarten Anschlußleiter verbunden sind, daß die Lage der Anschlußleiter bezogen auf die Halbleiteranordnungen für alle Paare von Halbleiteranordnungen bzw. für je zwei Paare von Halbleiteranordnungen gleich ist und daß einander entsprechende Anschlußleiter oberhalb der Leiterbahnen elektrisch miteinander verbunden sind.

Weiterbildungen der Erfindung sind Gegenstand der Unteransprüche.

Die Erfindung wird anhand einiger Ausführungsbeispiele in Verbindung mit den Figuren 1 bis 6 naher erläutert.
Es zeigen
Figur 1 die Aufsicht auf ein erstes Ausführungsbeispiel,
Figur 2 die Aufsicht auf ein zweites Ausführungsbeispiel,
Figur 3 den in Figur 1 verwirklichten Schaltkreis,
Figur 4 den in Figur 2 verwirklichten Schaltkreis,
Figur 5 eine Aufsicht auf ein drittes Ausführungsbeipsiel, und
Figur 6 eine Seitenansicht auf die Anordnung nach Figur 5.

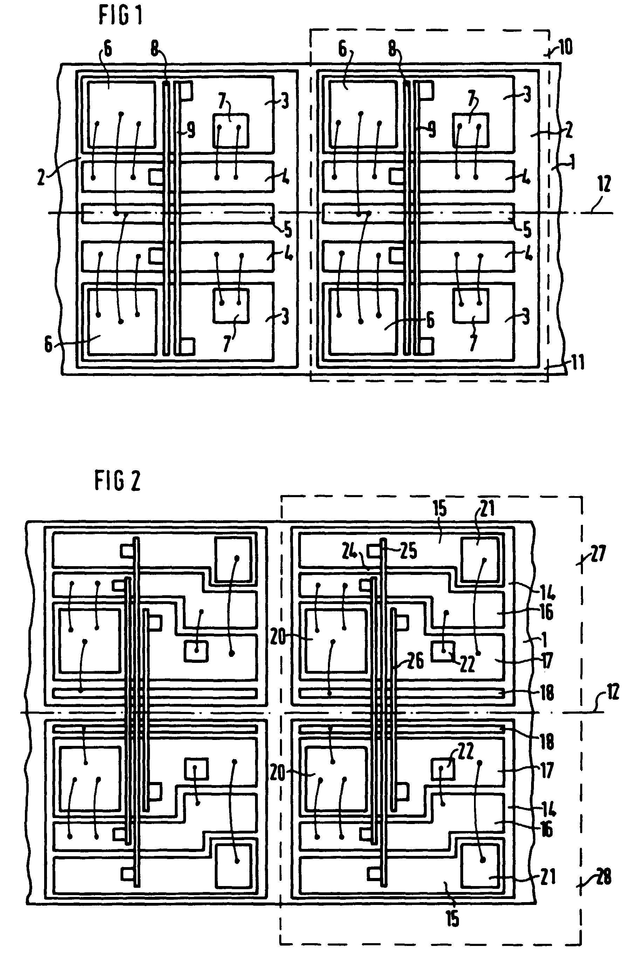

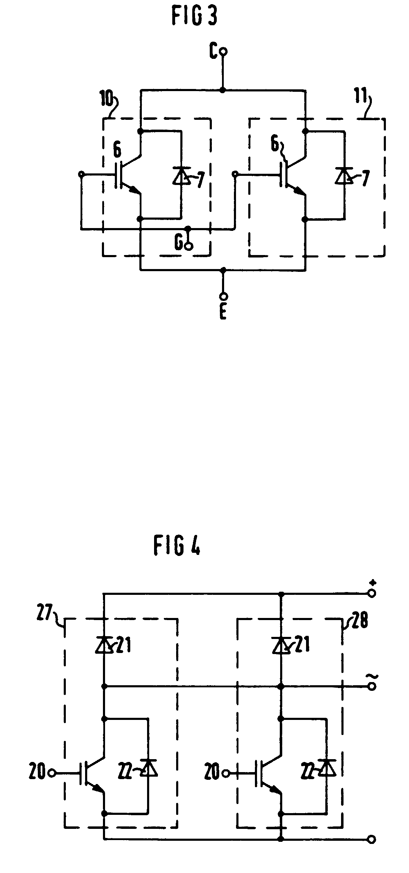

Das Leistungshalbleiter-Modul nach Figur 1 hat einen metallenen Boden 1, auf dem Isolierschichten 2 angeordnet sind. Die Isolierschichten 2 tragen Leiterbahnen 3, 4 und 5. Auf den Leiterbahnen sind spiegelsymmetrisch zu einer Symmetrieachse 12 Halbleiteranordnungen 10 und 11 untergebracht. Diese Halbleiteranordnungen bestehen z.B. aus einem feldeffektgesteuerten Halbleiterbauelement 6 und einer antiparallel geschalteten Diode 7. Das feldeffektgesteuerte Halbleiterbauelement kann z.B. ein MOSFET oder ein IGBT (Isolated Gate Bipolar Transistor) sein. Eine Seite der Halbleiterbauelemente ist direkt mit der Leiterbahn 3 kontaktiert, wahrend die andere Seite mit den Leiterbahnen 4 über Bonddrähte kontaktiert ist. Die Leiterbahn 5 dient zur Kontaktierung der Steueranschlüsse.

Die Leiterbahnen 3, 4 sind mit Anschlußleitern 8 bzw. 9 verbunden, die senkrecht auf den Leiterbahnen stehen. Die Anschlußleiter sind bandförmig, liegen einander parallel und sind dicht beieinander angeordnet.

Auf dem gleichen Boden 1 sind je nach der gewünschten Stromfähigkeit des Moduls mehrere den Halbleiteranordnungen 10, 11 gleiche Halbleiteranordnungen vorgesehen. Dabei hat jedes Paar von einander spiegelsymmetrisch gegenüberliegenden Halbleiteranordnungen zwei Anschlußleiter 8, 9. Die Lage der Anschlußleiter bezuglich der Halbleiteranordnungen ist in Richtung der Symmetrieachse 12 für jedes Paar von Halbleiteranordnungen gleich. D.h., daß auf dem Boden 1 eine der Stromtragfähigkeit entsprechende Anzahl von aus Anschlußleitern und Halbleiteranordnungen bestehenden Einheiten angeordnet sind, die untereinander völlig gleich sind. Die Halbleiteranordnungen 10, 11 jedes Paares werden durch die Anschlußleiter 8, 9 parallel geschaltet. Die Anschlußleiter 8, 9 jedes Paares werden oberhalb der Leiterbahnen durch band- oder plattenförmige Verbindungsleiter miteinander verbunden. Hierbei werden alle Anschlußleiter 8 durch einen ersten Verbindungsleiter und alle Anschlußleiter 9 durch einen zweiten Verbindungsleiter elektrisch zusammengefaßt.

Das elektrische Äquivalent zur Anordnung nach Figur 1 ist in Figur 3 dargestellt. Jede der Halbleiteranordnungen besteht aus einem IGBT, dem eine Freilaufdiode 7 parallel geschaltet ist.

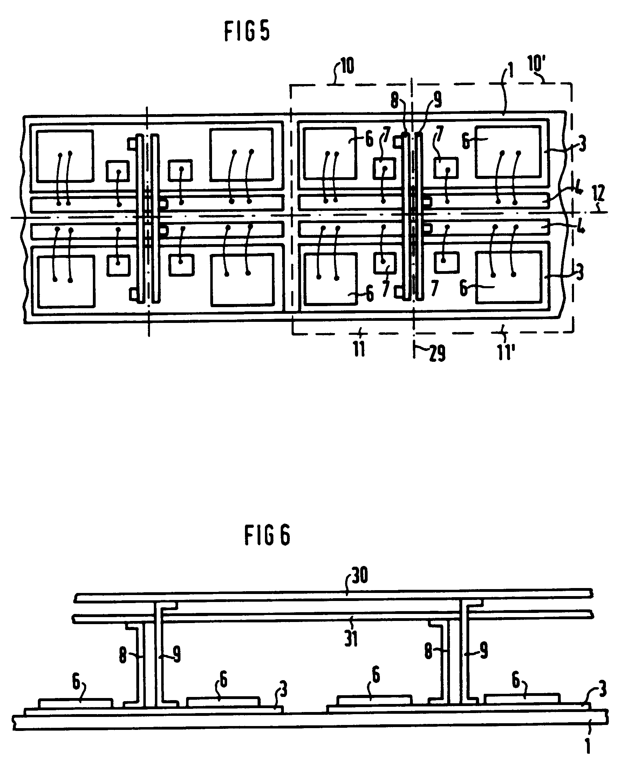

Das Ausführungsbeispiel nach Figur 2 baut wieder auf einem metallenen Boden 1 auf. Hier liegen sich spiegelsymmetrisch zur Symmetrieachse 12 Halbleiteranordnungen 27, 28 gegenüber, die je vier Leiterbahnen 15, 16, 17, 18 haben. Auf der Leiterbahn 15 ist eine Freilaufdiode 21 angeordnet, auf der Leiterbahn 17 ein feldeffektgesteuertes Halbleiterbauelement 20 und eine antiparallel geschaltete Schutzdiode 22. Das elektrische Äquivalent zur Anordnung nach Figur 2 ist in Figur 4 dargestellt. Es ist ein Brückenzweig mit den Anschlüssen Plus, Wechsel, Minus und besteht jeweils aus der Reihenschaltung der Diode 21 mit einem IGBT 20, dem die Schutzdiode 22 antiparallel geschaltet ist. HIerbei entspricht der Plusanschluß der Leiterbahn 15, der Wechselanschluß der Leiterbahn 16 und der Minusanschluß der Leiterbahn 17. Die Leiterbahn 18 ist mit dem Gateanschluß des IGBT 20 verbunden.

Die Leiterbahnen 15, 16 und 17 sind mit drei Anschlußleitern 24, 25, 26 verbunden, die jeweils senkrecht zur Ebene der Leiterbahnen einander parallel und dicht beieinanderliegend angeordnet sind. Diese Anschlußleiter schalten jeweils ein Paar von einander spiegelsymmetrisch gegenüberliegenden Halbleiteranordnungen 27, 28 parallel. Auf dem Boden 1 sind je nach Stromtragfähigkeit des Moduls weitere Paare von einander spiegelsymmetrisch gegenüberliegenden Halbleiteranordnungen angeordnet. Diese weiteren Paare von Halbleiteranordnungen sind ebenso wie beim Ausführungsbeispiel nach Figur 1 den ersten Paaren identisch. Sie werden jeweils durch drei Anschlußleiter 24, 25, 26 kontaktiert. Die Anschlußleiter jedes Paares von Halbleiteranordnungen werden wieder oberhalb der Ebene der Leiterbahnen durch je einen Verbindungsleiter miteinander verbunden. In diesem Falle sind drei Verbindungsleiter erforderlich.

Der symmetrische Aufbau der Module nach den Figuren 1 und 2 bewirkt, daß der Weg von den Halbleiterbauelementen 6, 7, 20, 21, 22 zu den zugeordneten Anschlußleitern immer gleich ist. Diese Symmetrie führt zu gleichen parasitären Induktivitäten für jede Anordnung und damit zu verbesserten elektrischen Eigenschaften.

In Figur 5 ist ein Leistungshalbleiter-Modul gezeigt, das wieder aus einander spiegelsymmetrisch zur Symmetrieachse 12 gegenüberliegenden Paaren von Halbleiteranordnungen 10, 11 besteht. Spiegelsymmetrisch zu den Halbleiteranordnungen 10 sind auf der gleichen Leiterbahn 3 weitere Halbleiteranordnungen 10', 11' angeordnet, wobei die zweite Symmetrieachse 29 in der Ebene der Leiterbahnen und rechtwinklig zur ersten Symmetrieachse 12 liegt. Die Paare 10, 11 und 10', 11' werden durch ein einziges Paar von Anschlußleitern 8, 9 kontaktiert. Auf dem Boden 1 sind dann entsprechend der gewünschten Stromtragfähigkeit mehrere solche Doppelpaare oder Viereranordnungen aufgebaut. Jedes der Doppelpaare oder Viereranordnungen wird durch ein Anschlußleiterpaar 8, 9 kontaktiert. Die einzelnen Anschlußleiterpaare 8, 9 jeder Vierergruppe sind dann wieder oberhalb der Leiterbahnen durch Verbindungsleiter kontaktiert. Die für die Steueranschlüsse benötigten Leiterbahnen sind hier der bessseren Übersichtlichkeit wegen weggelassen. Es empfiehlt sich eine Anordnung entsprechend des Moduls nach Figur 2.

Der doppelt spiegelsymmetrische Aufbau nach Figur 5 läßt sich z.B. auch für die Anordnung nach Figur 2 anwenden. Er bewirkt ebenfalls, daß der Weg von jedem der Halbleiterbauelemente 6 bzw. 20, 21 zum zugeordneten Anschlußleiter gleich ist. Damit sind auch die parasitären Induktivitäten gleich und eine gute Ausnutzbarkeit des Leistungshalbleiter-Moduls ist gewährleistet.

Eine weitere Verbesserung kann dadurch erreicht werden, daß jeder der mit einem Steueranschluß verbundenen Leiterbahnen mit einem Anschlußleiter verbunden ist und diese Anschlußleiter entsprechend den Anschlußleitern für den Laststrom oberhalb der Leiterbahnen miteinander verbunden werden.

In Figur 6 ist schematisch dargestellt, wie die einander zugehörigen Anschlußleiterpaare 8, 9 miteinander verbunden werden. Dies geschieht durch Verbindungsleiter 30, 31, die jeweils die Anschlußleiter 9 bzw. 8 miteinander verbinden. Die unterschiedliche Höhe der Anschlußleiter 8, 9 wurde lediglich der besseren Übersichtlichkeit halber gewählt, in der Praxis ist die Hohe sämtlicher Anschlußleiter zweckmäßigerweise gleich. Die Verbindungsleiter 30, 31 können innerhalb des Gehäuses liegen. Zweckmäßigerweise liegen sie jedoch auf dem Gehäuse, weil auf diese Weise mehrere Leistungshalbleiter-Module untereinander paralleel geschalteten werden können.

Mit den Ausführungsbeispielen nach den Figuren 1, 2 und 5 wird eine weitgehende Symmetrie der Stromführung erreicht. Werden an die Symmetrie weniger hohe Anforderungen gestellt, so reicht es aus, beidseitig der Achsen 12, 29 lediglich identische oder sogar im Aufbau voneinander abweichende Halbleiteranordnungen anzuordnen. Die Symmetrieachse 12 wird dann zu einer Achse des Moduls, hier zu einer Längsachse, die parallel zum Boden 1 und rechtwinklig zur Ebene der Anschlußleiter verläuft. Die Symmetrieachse 29 im Ausführungsbeispiel nach Figur 5 wird zu einer parallel zur Ebene der Anschlußleiter und zum Boden 1 liegenden Achse.

## Patentansprüche

1. Leistungshalbleiter-Modul mit einer Anzahl von sich entlang einer parallel zum Boden des Moduls liegenden Achse Paarweise gegenüberliegenden, auf Leiterbahnen angeordneten und parallelgeschalteten Halbleiteranordnungen, mit eng benachbarten und einander Parallelen bandförmigen Anschlußleitern, die mit den Leiterbahnen verbunden sind,
**dadurch gekennzeichnet**, daß mindestens ein Paar und höchstens je zwei Paare von in Richtung der Achse (12) hintereinanderliegenden Halbleiteranordnungen (10, 11; 27, 28) mit mindestens zwei der eng benachbarten Anschlußleiter (8, 9; 24, 25, 26) verbunden sind, daß die Lage der Anschlußleiter bezogen auf die Halbleiteranordnungen für alle Paare von Halbleiteranordnungen bzw. für je zwei Paare von Halbleiteranordnungen gleich ist und daß einander entsprechende Anschlußleiter oberhalb der Leiterbahnen elektrisch miteinander verbunden sind.

2. Leistungshalbleiter-Modul nach Anspruch 1,
**dadurch gekennzeichnet,** daß bei je zwei in Richtung der Achse (12) hintereinanderliegenden parallel geschalteten Paaren (10, 11; 10', 11') die Anschlußleiter (8, 9) zwischen den zwei Paaren angeordnet sind.

3. Leistungshalbleiter Modul nach Anspruch 1 oder 2,
**dadurch gekennzeichnet,** daß die Halbleiteranordnungen feldeffektgesteuerte Halbleiterbauelemente (6, 20) sind, denen je eine Freilaufdiode (7, 22) antiparallel geschaltet ist.

4. Leistungshalbleiter-Modul nach Anspruch 1 oder 2,
**dadurch gekennzeichnet**, daß die Halbleiteranordnungen eine Reihenschaltung aus einer Diode (21) und einem feldeffektsteuerten Halbleiterbauelement (20) enthalten, daß der Knoten der Reihenschaltung über eine Leiterbahn (15) mit einem dritten bandförmigen Anschlußleiter (24) verbunden ist, der den anderen zwei Anschlußleitern (25, 26) eng benachbart ist und daß die dritten Anschlußleiter (24) oberhalb der Leiterbahnen miteinander verbunden.

5. Leistungshalbleiter-Modul nach Anspruch 1,
**dadurch gekennzeichnet**, daß die entlang der Achse (1, 2) einander gegenüberliegenden Halbleiteranordnungen spiegelsymmetrisch zur Achse des Moduls ausgebildet sind.

6. Leistungshalbleiter-Modul nach Anspruch 2,
**dadurch gekennzeichnet**, daß die zu beiden Seiten der Anschlußleiter liegenden Paare von Halbleiteranordnungen (10, 10'; 11, 11') jeweils spiegelsymmetrisch zur Ebene der Anschlußleiter ausgebildet sind.

7. Leistungshalbleiter-Modul nach einem der Ansprüche 1 bis 6,
**dadurch gekennzeichnet**, daß die Halbleiteranordnungen von einem Gehäuse umschlossen und die Anschlußleiter außerhalb des Gehäuses durch Verbindungsleiter (30, 31) miteinander verbunden sind.

## Claims

1. Power semiconductor module having a number of semiconductor arrangements which are connected in parallel, are arranged on conductor tracks and lie opposite one another in pairs along an axis lying parallel to the bottom of the module, having connecting conductors which are in strip form, are closely adjacent and parallel to one another and are connected to the conductor tracks, characterized in that at least one pair and at most in each case two pairs of semiconductor arrangements (10, 11; 27, 28) lying one behind the other in the direction of the axis (12) are connected to at least two of the closely adjacent connecting conductors (8, 9; 24, 25, 26), in that the position of the connecting conductors with respect to the semiconductor arrangements is the same for all pairs of semiconductor arrangements or for each two pairs of semiconductor arrangements, and in that mutually corresponding connecting conductors are electrically connected to one another above the conductor tracks.

2. Power semiconductor module according to Claim 1, characterized in that, with in each case two pairs (10, 11; 10', 11') connected in parallel and lying one behind the other in the direction of the axis (12), the connecting conductors (8, 9) are arranged between the two pairs.

3. Power semiconductor module according to Claim 1 or 2, characterized in that the semiconductor arrangements are field effect-controlled semiconductor components (6, 20) with which a respective freewheeling diode (7, 22) is reverse-connected in parallel.

4. Power semiconductor module according to Claim 1 or 2, characterized in that the semiconductor arrangements contain a series circuit formed by a diode (21) and a field effect-controlled semiconductor component (20), in that the node of the series circuit is connected via a conductor track (15) to a third connecting conductor (24), which is in strip form and is closely adjacent to the other two connecting conductors (25, 26), and in that the third connecting conductors (24) are connected to one another above the conductor tracks.

5. Power semiconductor module according to Claim 1, characterized in that the semiconductor arrangements lying opposite one another along the axis (1, 2) are of mirror-symmetrical construction with respect to the axis of the module.

6. Power semiconductor module according to Claim 2, characterized in that the pairs of semiconductor arrangements (10, 10', 11, 11') lying on both sides of the connecting conductors are each of mirror-symmetrical construction with respect to the plane of the connecting conductors.

7. Power semiconductor module according to one of Claims 1 to 6, characterized in that the semiconductor arrangements are enclosed by a housing and the connecting conductors are connected to one another outside the housing by means of connection conductors (30, 31).

## Revendications

1. Module à semiconducteurs de puissance, comportant un certain nombre de circuits à semiconducteurs se faisant face par paires le long d'un axe s'étendant parallèlement au fond du module, montés sur des pistes conductrices et branchés en parallèle, comportant des conducteurs de raccordement en ruban qui sont étroitement voisins et parallèles les uns aux autres et qui sont reliés aux pistes conductrices, caractérisé en ce qu'au moins une paire et au plus chaque groupe de deux paires de circuits (10, 11; 27, 28) à semiconducteurs montés l'une derrière l'autre dans la direction de l'axe (12) sont reliés à au moins deux des conducteurs (8, 9; 24, 25, 26) de raccordement étroitement voisins, en ce que la position des conducteurs de raccordement par rapport aux circuits à semiconducteurs est la même pour toutes les paires de circuits à semiconducteurs ou pour chaque groupe de deux paires de circuits à semiconducteurs, et par le fait que des conducteurs de raccordement se correspondant les uns les autres sont reliés électriquement entre eux au-dessus des pistes conductrices.

2. Module à semiconducteurs de puissance suivant la revendication 1, caractérisé en ce que, pour chaque groupe de deux paires (10, 11; 10', 11') montées l'une derrière l'autre en série dans la direction de l'axe (12) et branchées en parallèle, les conducteurs (8, 9) de raccordement sont disposés entre les deux paires.

3. Module à semiconducteurs de puissance suivant la revendication 1 ou 2, caractérisé en ce que les circuits à semiconducteurs sont des composants (6, 20) à semiconducteurs commandés par effet de champ, avec lesquels une diode (7, respectivement 22) de roue libre est branchée tête-bêche.

4. Module à semiconducteurs de puissance suivant la revendication 1 ou 2, caractérisé en ce que les circuits à semiconducteurs comportent un circuit-série constitué d'une diode (21) et d'un composant (20) à semiconducteurs commandé par effet de champ, en ce que le noeud du circuit-série est relié, par l'intermédiaire d'une piste (15) conductrice, à un troisième conducteur (24) de raccordement en forme de ruban, qui est étroitement voisin des deux autres conducteurs (25, 26) de raccordement , et en ce que les troisièmes conducteurs (24) de raccordement sont reliés entre eux au-dessus des pistes conductrices.

5. Module à semiconducteurs de puissance suivant la revendication 1, caractérisé en ce que les circuits à semiconducteurs, qui se font face par paire le long de l'axe (12), sont symétriques comme en un miroir par rapport à l'axe du module.

6. Module à semiconducteurs de puissance suivant la revendication 2, caractérisé en ce que les paires de circuits (10, 10'; 11, 11') à semiconducteurs, se trouvant de part et d'autre des conducteurs de raccordement, sont symétriques comme en un miroir par rapport au plan des conducteurs de raccordement.

7. Module à semiconducteurs de puissance suivant l'une des revendications 1 à 6, caractérisé en ce que les circuits à semiconducteurs sont entourés d'un boîtier et les conducteurs de raccordement reliés entre eux à l'extérieur du boîtier par des conducteurs (30, 31) de liaison.
